Europäisches Patentamt

European Patent Office

Office européen des brevets

(11) Publication number: **0 387 102**
**A2**

## EUROPEAN PATENT APPLICATION

(21) Application number: **90302589.8**

(22) Date of filing: **12.03.90**

(51) Int. Cl.5: **G11C 16/04, G11C 16/06**

(30) Priority: **10.03.89 JP 58174/89**

(43) Date of publication of application:
**12.09.90 Bulletin 90/37**

(84) Designated Contracting States:
**DE FR GB**

(71) Applicant: **SEIKO INSTRUMENTS INC.**
**31-1, Kameido 6-chome Koto-ku**
**Tokyo 136(JP)**

Applicant: **AGENCY OF INDUSTRIAL SCIENCE**
**AND TECHNOLOGY**
**3-1, 1-chome, Kasumigaseki**
**Chiyoda-ku Tokyo(JP)**

(72) Inventor: **Hayashi, Yutaka, c/o Agency of**
**Industrial Science**
**and Technology, 1-4 Umezono 1-chome**
**Tsukuba-shi, Ibaragi(JP)**
Inventor: **Kojima, Yoshikazu**
**c/o Seiko Instruments Inc., 31-1 Kameido**
**6-chome**
**Koto-ku, Tokyo(JP)**
Inventor: **Takada, Ryoji**
**c/o Seiko Instruments Inc., 31-1 Kameido**
**6-chome**
**Koto-ku, Tokyo(JP)**
Inventor: **Kamiya, Masaaki**
**c/o Seiko Instruments Inc., 31-1 Kameido**
**6-chome**
**Koto-ku, Tokyo(JP)**

(74) Representative: **Caro, William Egerton et al**
**J. MILLER & CO. Lincoln House 296-302 High**
**Holborn**
**London WC1V 7JH(GB)**

(54) **Semi-conductor non-volatile memory and method of writing the same.**

(57) A semi-conductor non-volatile memory comprises one or more integrated memory cells. Each memory cell comprises a first semi-conductor region having a first surface, and electric charge storage structure (5) disposed on the first surface for storing electric charge and a first gate (7) electrically coupled to the electric charge storage structure. There is a second region electrically connected to the first surface and a second gate (9) electrically coupled to either the electric charge storage structure or the first gate. A random access potential setting means (9 - 11) sets a random access potential to the first gate (7).

FIG.1

## SEMI-CONDUCTOR NON-VOLATILE MEMORY AND METHOD OF WRITING THE SAME

This invention relates to semi-conductor non-volatile memories which can store information even when a power supply is turned off, and to methods of writing such semi-conductor non-volatile memories.

There have been proposed various types of conventional non-volatile memory elements (memory cells) such as MAOS type, FAMOS type, MIOS type, etc. The structure of these memories are different. For example, as an electric charge storage structure for non-volatile storing of logic information in the form of electric charge, an electro-conductive film buried in an electrically insulating layer (i.e. a floating gate) can be used. Alternatively, a multi-layer of dielectric material and a ferro-electric film can be utilised. Further, there have been various injection and extraction methods for selectively injecting and extracting electric charge into and from an electric charge storage structure in order to change the charged state thereof. These methods include avalanche injection, tunnel injection, channel injection and tunnel extraction of electric charge from the electric charge storage structure to change the charged state opposite to the polarity of the extracted electric charge.

The charged state of individual memory cells can be erased concurrently by irradiation by ultraviolet rays or x-rays. Further, by suitable combination of these electric charge injection and extraction methods, one polarity type of electric charge is restored into or extracted from a storage structure, which has stored therein the other polarity type of electric charge, to enable electrical erasing and re-writing of memorised contents. These types of memories are called EAROM and E²PROM.

A semi-conductor region is formed in opposed relation to the electric charge storage structure or an insulating gate region is electrically coupled to the electric charge storage structure for use in feeding electric charge to be injected into the electric charge storage structure and for use in receiving electric charge extracted from the storage structure.

Moreover, in practical IC devices, these various types of non-volatile memory element (memory cell) are combined with a static RAM cell (random access memory). Very recently, it has been proposed in Japanese Patent Application No. 4635/1987 that change of surface potential of a semi-conductor region can be utilised for random access writing or temporary writing prior to non-volatile writing.

This random access writing method is conventionally applied to the non-volatile memory cell.

However, when carrying out random access reading without effecting non-volatile writing, the information is automatically erased. Moreover, the smaller the size of the memory cell, the smaller the read signal and this causes serious drawbacks. Further, according to this conventional method, when a memory cell has a relatively small efficiency of electric charge capture in the storage structure, the signal-to-noise ratio of the signal representative of the contents of the non-volatile memory becomes worse, thereby making it difficult to use commercially.

The present invention seeks to provide a semi-conductor non-volatile memory which can be used as a volatile memory and a non-volatile memory and which can avoid erasure of information even after carrying out random access reading and seeks to provide a method of writing such a non-volatile memory.

According to one aspect of the present invention there is provided a semi-conductor non-volatile memory comprising one or more integrated memory cells characterised in that the or each memory cell comprises a first semi-conductor region having a first surface, an electric charge storage structure disposed on the first surface for storing electric charge, a first gate electrically coupled to the electric charge storage structure, a second region electrically connected to the first surface, a second gate electrically coupled to either the electric charge storage structure or the first gate, and random access potential setting means for setting a random access potential to the first gate.

According to another aspect of the present invention there is provided a method of writing a semi-conductor non-volatile memory according to the present invention comprising temporarily setting or writing a given potential to the first gate through the random access potential setting means prior to applying a given voltage to the second gate to effect non-volatile writing, and thereafter applying concurrently a non-volatile writing voltage according to a non-volatile writing instruction to the second gate so as to volatile write the temporary written information in the form of the set potential into the respective electric charge storage structure.

According to a further aspect of the present invention there is provided a semi-conductor memory formed on a substrate characterised by comprising: storage means disposed on the substrate for storing electric charge to memorise non-volatile information; injecting means for injecting electric charge into the storage means; first control gate means disposed adjacent to the storage means and operable temporarily to store volatile information in the form of its potential level effective to control the potential level of the storage means; random access means for setting the potential level of the first control gate means on a random access basis to write temporarily volatile information into the first control gate means; and second control gate means disposed adjacent to the storage means for applying thereto a control voltage to effect the injection of electric charge from the injecting means to the storage means according to the set potential level of the first control gate means thereby to enable the storage means to memorise non-volatile information corresponding to the temporarily written volatile information.

The storage means may comprise a floating electrode.

The injecting means may comprise drain and source regions and a channel region disposed under the storage means between the drain and source regions.

The first control gate means may comprise a gate region disposed under the storage means and capacitively coupled thereto. Alternatively the first control gate means may comprise a gate electrode disposed over the storage means and capacitively coupled thereto.

The second control gate means comprise a gate electrode disposed over the storage means and capacitively coupled thereto.

The random access means may comprise input means disposed in spaced relation from the first control gate, a channel region for inputting volatile information to the first control gate means, and gate means disposed on the channel region for turning on the channel region on a random access basis.

Preferably the random access means includes a switching transistor connected to the gate means to effect random access thereof. The input means, the gate means and the second control gate means may be comprised of a thin film transistor.

The expression "electrically coupled" means that the first gate and the electric charge storage structure are capacitively coupled to each other, or that the first gate is constructed to apply an electric field to the electric charge storage structure. The expression "electrically connected second region" means that, when the first semi-conductor region is composed of a channel of the buried type, the second region is a region in ohomic contact with the first semi-conductor region, or that, when an inverted region is formed on the first semi-conductor region, the second region is a region effective to exchange carriers to and from the inverted channel. In most cases, the second region is composed of a semi-conductor region. In some cases, a region composed of metal or silicide may function as the second region.

Further, the electric charge storage structure can be formed as a multi-layer structure of dielectric films, an electro-conductive material buried in an insulating layer, or ferro-electric material. When the electro-conductive material extends horizontally outside the first surface of the first semi-conductor region, the first insulating gate is not necessarily disposed over the surface of the first semi-conductor region, but may be capacitively coupled to the electro- conductive material through an insulating film. Further, in the case where the electric charge storage structure is formed of a multi-layer structure of dielectric films or ferro-electric film, the second gate electrode is disposed on the first surface of the first semi-conductor region to an insulating film or the electric charge storage structure. According to the potential applied to the second gate electrode, the potential of the semi-conductor surface of the first semi-conductor region and an electric field of the electric charge storage structure or an electric field of an insulating film in contact with the storage structure can be controlled to effect the injection and extraction of electric charge into and from the electric charge storage structure. Namely, the charged state of the storage structure can be changed.

Further, the random access potential setting means can be composed of a switching element such as a diode and transistor connected to the first gate and functions to set the potential of the first gate according to information to be written and thereafter to maintain temporarily the set potential for a given duration. Further, the random access potential setting means may include an additional element such as a transistor or diode having the function to select a floating state or fixed potential state of the first control gate. The time needed for setting the potential is far smaller than the time needed for carrying out non-volatile writing. Consequently, information can be quickly set to the semi-conductor non-volatile memory just prior to carrying out non-volatile writing. When carrying out non-volatile writing, the volatile or temporary information just set is transferred into the corresponding storage structure at once as non-volatile information. Namely, in the present invention, information can be instantly written in the non-volatile state in a semi-conductor non-volatile memory.

Further, a switching element such as a diode or transistor is connected to a volatile information input gate, and this switching element is used as the random access potential setting means so as to write volatile information into the volatile information input gate. Then the volatile information is written into the first control gate according to the information at the volatile information input gate. Thus, when applying a high voltage to the second control gate, electric charge is injected into or released from the electric charge storage structure corresponding to the volatile information thereby to write the information in a non-volatile state.

The invention is illustrated, merely by way of example, in the accompanying drawings, in which:-

Figure 1 is a sectional view of a first embodiment of a semi-conductor non-volatile memory according to the present invention;

Figure 2 is a sectional view of a second embodiment of a semi-conductor non-volatile memory according to the present invention;

Figure 3 is a sectional view of a third embodiment of a semi-conductor non-volatile memory according to the present invention;

Figure 4 is a sectional view of a thin film diode utilised as a non-volatile information setting means of a fourth embodiment of a semi-conductor non-volatile memory according to the present invention; and

Figure 5 is a sectional view of a fifth embodiment of a semi-conductor non-volatile memory according to the present invention.

Throughout the drawings like parts have been designated by the same reference numerals.

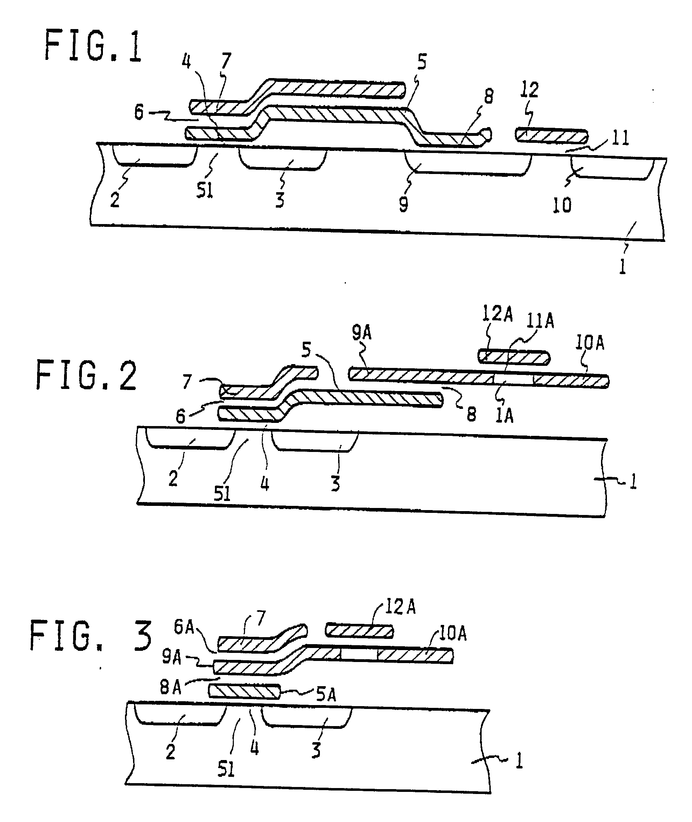

Figure 1 is a sectional view of a single memory cell of a first embodiment of a semi-conductor non-volatile memory according to the present invention. An $N^+$ type source region 2 and a drain region 3 are formed on a surface of a P type silicon substrate 1 in spaced relation to each other to function as a second region which, in this embodiment, is comprised of two sections. A first semi-conductor region 51 is defined on a surface portion of the substrate 1 between the source region 2 and the drain region 3. A floating gate is formed on the first semi-conductor region 51 through a gate oxide film 4. A second control gate 7 is formed on the floating gate 5 through a second control gate insulating film 6, and an $N^+$ type first control gate region 9 is formed under the floating gate through a first control gate insulating film 8 in a surface portion of the substrate 1. The second control gate 7 and the first control gate 9 are strongly capacitively coupled to the floating gate 5 so as to control the potential thereof.

A writing method according to the present invention will now be explained. A switching transistor is formed to operate as a random access potential setting means and is comprised of the first control gate region 9, a volatile information input region 10 disposed in spaced relation to the first control gate region 9, and a volatile information input gate 12 formed on a gate oxide film 11. A potential of the first control gate region 9 is set according to the potential of the volatile information input region 10 in response to a signal to the volatile information input gate 12. Namely, volatile information can be written in the first control gate region 9 in the form of a set random access potential. For example, in the condition where the volatile information input gate 12 is applied with a voltage exceeding the threshold voltage of the switching transistor, when a voltage 0 V (equal to the potential of the substrate 1) is applied to the volatile information input region 10, the potential of 0 V is set in the first control gate region 9. On the other hand, when 5 V of a power supply voltage is applied to the volatile information input region 10, about 5 V of the potential is set in the first control gate region 9 as the volatile information. Thereafter, the potential of the volatile information input gate 12 is switched to 0 V to turn off the switching transistor so that the volatile information is temporarily held in the first control gate region 9 for several milli-seconds.

Next, the conversion of volatile information written in the first control gate region 9 into the corresponding non-volatile information in the floating gate 5 will be explained. A potential of the drain region 3 is set to 0 V and the second control gate 7 is applied with a high voltage of more than 10 V. The gate oxide film 4 is entirely or partly formed of a tunnel oxide film of about 50Å thickness. Therefore, by holding the second control gate 7 at a high voltage, the floating gate 5 is held at a high voltage through the capacitive coupling such that a high electric field is applied to the tunnel oxide film so that electrons are injected into the floating gate 5 from the substrate 1 through the tunnel oxide film. At this stage, the potential of the floating gate 5 is controlled also by the other control gate, i.e. the first control gate region 9. Accordingly, when the first control gate region 9 is storing volatile information in the form of a high potential level of about 5 V, the potential of the floating gate 5 is additionally boosted to a higher level so that more electrons are injected into the floating gate 5. On the other hand, when the potential of the first control gate region 9 is held at 0 V, the potential of the floating gate 5 is drawn to the 0 V side such that less electrons are injected into the floating gate 5 from the substrate. Namely, the quantity of electrons injected into the floating gate 5 from the substrate 1 can be regulated according to the magnitude of the volatile information written in the first control gate region 9 from the volatile information input terminal 10 by means of the volatile information input gate 12. Since the exchange of electric charge is effected between the substrate 1 and the floating gate 5, the electric charge on the first control gate region 9 is almost unchanged. Since the electrons stored in the floating gate 5 do not dissipate to the surrounding insulating layer, the charge on the floating gate 5 is converted into corresponding non-volatile information. By setting the difference between the maximum and minimum values of the potential temporarily set in the first control gate region 9 to more than 5 V, the change in the quantity of the injected electrons can be increased according to the volatile information. The non-volatile information written in the floating gate 5 can be erased by irradiation with ultra-violet rays or by application of a reverse high voltage to the tunnel oxide film.

Since the floating gate 5 is capacitively coupled to the first control gate region 9 which can memorise volatile information, non-volatile writing can be effected by means other than utilising the tunnel oxide film. For example, in the state where a voltage of 0 V is applied to the source region 2 and a high voltage of more than 5 V is applied to the drain region 3, and a high voltage of more than 10 V is applied to the second control gate 7, when the first control gate region 9 is held at a potential of 5 V, the floating gate 5 is held at a relatively high potential level so that the floating gate 5 is injected with a great quantity of channel hot electrons generated in the vicinity of the drain region 3. On the other hand, when the first control gate region 9 is held at 0 V, the potential of the floating gate 5 is held at a relatively low level so that the floating gate 5 is injected with only a small quantity of channel hot electrons.

As described above, the volatile information can be easily and quickly converted into the corresponding non-volatile information. In order to write a large amount of information at once, the method of utilising efficient tunnel current is most suitable from the point of view of low electric current consumption.

Next, the method of reading written non-volatile information will be explained. In the case where a constant voltage (for example 0 V) is applied to the second control gate 7 and the first control gate region 9, channel conductance is monitored in the first semi-conductor region 51 formed on a surface portion of the substrate 1 between the source region 2 and the drain region 3 thereby to read the non-volatile information. Namely, when a great quantity of electrons has been injected into the floating gate 5, the semi-conductor region 51 is held in a low conductance state. When a small quantity of electrons or great quantity of positive holes have been stored in the floating gate 5, the semi-conductor region 51 is held in a high conductance state.

As described above, according to the present invention, the volatile information inputted from the volatile information input region 10 is easily transferred into the floating gate 5 in the form of non-volatile information. Further, by monitoring the channel conductance of the first semi-conductor region 51 between the source region 2 and the drain region 3 which are separate from the volatile information input region 10, the non-volatile information can be efficiently read out.

In Figure 1, the first control gate region 9 is set to a high potential of more than 5 V as the volatile information, hence the corresponding non-volatile information can be correctly written. When carrying out non-volatile writing, the potential level of the first control gate region 9 has a great influence. Further, since leakage current through the insulating film 8 on the first control gate region 9 is extremely small during non-volatile writing, the information temporarily written in the first control gate region 9 is stably maintained. Thus stable non-volatile writing can be carried out.

In Figure 1 the first control gate region 9 is formed in the surface of the substrate 1. However, in Figure 2 which shows a single memory cell of a second embodiment of a semi-conductor non-volatile memory according to the present invention, a switching transistor is formed as a thin film transistor for setting the potential of the first control gate region 9.

The switching transistor is composed of a channel forming region 1A composed of a thin film made of, for example, polysilicon or mono-crystalline silicon. The potential level of a first control gate 9A is controlled by the potential level of a volatile information input gate 12A and by the potential level of a volatile information input terminal 10A which has the same function as that of the information input region 10 of Figure 1 so as to write volatile information in a similar manner to the semi-conductor non-volatile memory of Figure 1. In Figure 2, since the first control gate 9A is formed of a thin film, memory cells can be integrated at a higher density.

Figure 3 is a sectional view of a single memory cell of a third embodiment of a semi-conductor non-volatile memory according to the present invention. An electric charge storage dielectric film 5A is utilised as a non-volatile storage means. Since an electric charge storage structure is composed of the electric charge storage dielectric film 5A formed as a dielectric film, a first control gate 9A is formed on the electric charge storage dielectric film 5A through an insulating film 8A. In a similar manner to the semi-conductor non-volatile memory of Figure 1, the volatile information is written into the first control gate 9A, the written volatile information is transferred to the electric charge storage film 5A in the form of corresponding non-volatile information, and the non-volatile information is read out by monitoring change of channel conductance of the first semi-conductor region 51 between source region 2 and drain region 3.

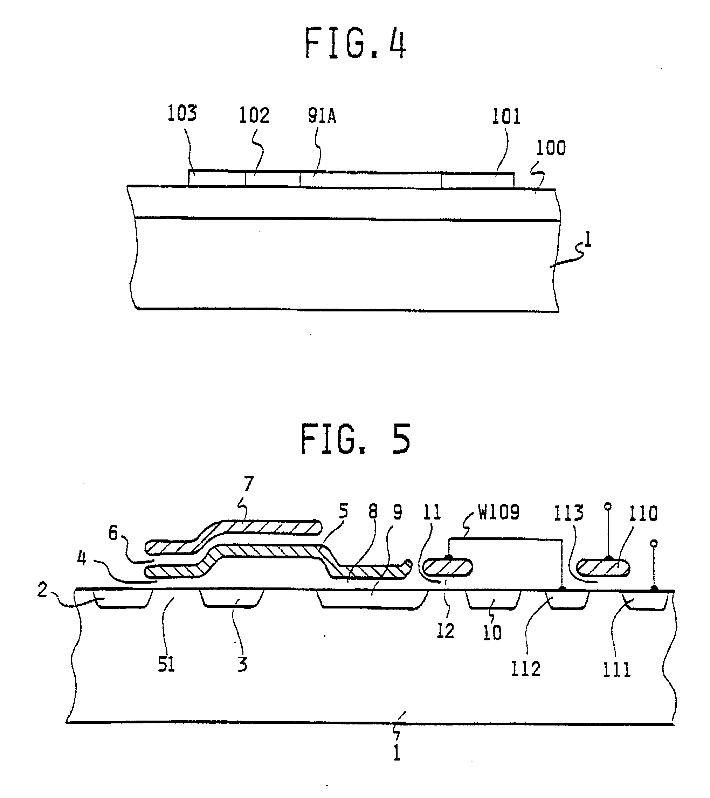

Figure 4 is a sectional view showing a fourth embodiment of a semi-conductor non-volatile memory according to the present invention in which a diode is utilised as random access potential setting means. The memory includes a semi-conductor substrate 1 and a field insulating film 100. A polysilicon film is formed on the insulating film 100. By doping impurity into the polysilicon film, a first control gate 91A of N type polysilicon and a P type polysilicon film 101 are formed to constitute a PN diode and an N type polysilicon film 103 and a P type polysilicon film 102 are formed to constitute an opposite NP diode. Because of the rectifying function of the diodes, the potential level of the first control gate can be set between 0 V and the power source voltage to write volatile information. The thus set information can be converted into the corresponding non-volatile information and further the non-volatile information can be read out in a manner similar to that of the semi-conductor non-volatile memories of Figures 1 to 3.

Figure 5 is a sectional view showing a single memory cell of a fifth embodiment of a semi-conductor non-volatile memory according to the present invention. In this embodiment, the volatile information input gate 12 of Figure 1 is added to a random access potential setting means in the form of an additional transistor. An N$^+$ type source region 112 and drain region 111 are formed in a surface portion of the P type semi-conductor substrate 1. A gate electrode 110 is formed on a surface portion of the substrate 1 between the source region 112 and drain region 111 through a gate insulating film 113 to constitute a field effect transistor. This transistor can be operated to function as a random access potential setting means so as to write volatile information in a random access manner into the volatile information input gate 12. Namely, by applying a voltage more than the threshold voltage to the gate electrode 110 and by applying selectively a voltage of 0 V or a positive voltage Vs to the drain region 111, the volatile information input gate 12 is set to 0 V through a lead line W109 when the drain region 111 is supplied with 0 V, or the volatile information input gate 12 is set to the positive voltage Vs through the lead line W109 when the drain region 111 is held at the positive voltage Vs. Thereafter, the voltage of the gate electrode 110 is returned to 0 V. By such random access potential setting means, the volatile information is written into the volatile information input gate 12. Then, according to the written volatile information, the impedance of a channel region under the volatile information input gate 12 is changed. Namely, when the volatile information input gate 12 is stored with volatile information in the form of the positive potential Vs, the channel region is made conductive and therefore the first control gate 9 is connected to the volatile information input region 10. Therefore, when a voltage of 0 V is applied to the volatile information input region 10, the first control gate 9 is accordingly held at 0 V. On the other hand, when the volatile information input gate 12 is written with the volatile information of 0 V, the channel region below the information input gate 12 has high impedance so that the first control gate 9 is held at a floating potential. Consequently, by applying a high voltage to the second control gate 7, when the potential of the first control gate 9 is held at 0 V, the potential of the floating gate electrode 5 is drawn to the 0 V potential of the first control gate 9, thereby to suppress raising of the potential of the floating gate electrode so that electrons are not injected into the floating gate electrode 5 from the substrate 1. On the other hand, when the potential of the first control gate 9 is floating, the potential of the floating gate electrode 5 is boosted sufficiently to a high level by means of the second control gate 7 such that electrons are injected into the floating gate electrode 5 from the substrate 1.

As the method of injecting electrons from the substrate 1, the gate oxide film 4 is formed with a thickness of about 10Å, and the potential difference is made zero between the source region 2 and the drain region 3. Consequently, a high electric field is applied to the gate oxide film 4 to cause a tunnel current to flow to inject electrons into the floating gate electrode 5.

Alternatively, a high voltage of about 10 V is applied to the drain region 3 and a voltage of 0 V is applied to the source region 2 to generate channel hot electrons in the vicinity of the drain region 3, a part of which is injected into the floating gate electrode 5.

As described above, the random access potential setting means composed of a transistor is operated to set volatile information, which is subsequently programmed into non-volatile information. Therefore, an array of the memory cells can be constructed as a matrix having word lines and bit or data lines connected, respectively, to the gate 110 and the drain region 111 of each transistor which constitutes the random access potential setting means. The volatile information is instantly written into the array by means of the random access potential setting means, and thereafter non-volatile information is programmed into all memory cells of the array concurrently according to the written volatile information by applying a high voltage to the second control gate of all the memory cells.

The embodiments of Figures 2 and 3 can also be provided with random access potential setting means in a manner similar to the Figure 5 embodiment. In the Figure 5 embodiment, the random access potential setting means is comprised of a transistor formed in a common substrate. However, the transistor can be formed in a thin semi-conductor film disposed on an insulating substrate.

In the aforementioned embodiments, the first and second semi-conductor regions are formed on the semi-conductor substrate. However, the semi-conductor region 5 can be composed of a semi-conductor region of opposite conductivity type formed within the substrate, or these semi-conductor regions can be formed of a semi-conductor film disposed on an insulating substrate.

Further, when arranging the memory cells in a matrix array, word lines are connected to a gate of the transistors and bit or data lines are connected to a drain of the transistors which constitute the respective random access potential setting means of the memory cells so as to selectively write volatile information into the respective memory cells. The information written in each memory cell can be selectively read out by connecting the second control gate to the word line and by connecting the second region to the bit line. In some of the array structures, the drain of a transistor of the random access potential setting means (i.e. the volatile information input region) can be arranged common to the second region.

As described above, according to the present invention, a memory cell of a semi-conductor non-volatile memory is comprised of volatile information generating means composed of a diode or transistor, and programming means for programming the volatile information into an electric charge storage structure as the corresponding non-volatile information. Therefore, the memory cells have a simplified structure effective to facilitate construction of a high bit arrangement. Moreover, volatile information setting can be carried out instantly at high speed by the random access potential setting means, and thereafter the volatile information can be programmed at once into the corresponding non-volatile information, thereby achieving the effect of high speed programming of an array of memory cells.

## Claims

1. A semi-conductor non-volatile memory comprising one or more integrated memory cells characterised in that the or each memory cell comprises a first semi-conductor region having a first surface, an electric charge storage structure (5, 5A) disposed on the first surface for storing electric charge, a first gate (7) electrically coupled to the electric charge storage structure, a second region electrically connected to the first surface, a second gate (9, 9A) electrically coupled to either the electric charge storage structure or the first gate, and random access potential setting means (9 - 11; 9A - 11A; 100 - 103) for setting a random access potential to the first gate (7).

2. A method of writing a semi-conductor non-volatile memory as claimed in claim 1 characterised by temporarily setting or writing a given potential to the first gate (7) through the random access potential setting means (9 - 11; 9A - 11A; 100 - 103) prior to applying a given voltage to the second gate (9, 9A) to effect. non-volatile writing, and thereafter applying concurrently a non-volatile writing voltage according to a non-volatile writing instruction to the second gate (9, 9A) so as to volatile write the temporary written information in the form of the set potential into the respective electric charge storage structure (5, 5A).

3. A semi-conductor memory formed on a substrate (1) characterised by comprising: storage means (5, 5A) disposed on the substrate for storing electric charge to memorise non-volatile information; injecting means (2, 3, 51) for injecting electric charge into the storage means; first control gate means disposed adjacent to the storage means (5, 5A) and operable temporarily to store volatile information in the form of its potential level effective to control the potential level of the storage means; random access means (9 -11; 9A - 11A; 100 - 103) for setting the potential level of the first control gate means (7) on a random access basis to write temporarily volatile information into the first control gate means; and second control gate means (9, 9A) disposed adjacent to the storage means for applying thereto a control voltage to effect the injection of electric charge from the injecting means (2, 3, 51) to the storage means (5, 5A) according to the set potential level of the first control gate means (7) thereby to enable the storage means to memorise non-volatile information corresponding to the temporarily written volatile information.

4. A semi-conductor memory as claimed in claim 3, characterised in that the storage means comprises a floating electrode (5, 5A).

5. A semi-conductor memory as claimed in claim 3 or 4 characterised in that the injecting means comprises drain and source regions (3, 2) and a channel region (51) disposed under the storage means (5, 5A) between the drain and source regions.

6. A semi-conductor memory as claimed in any of claims 3 to 5 characterised in that the first control gate means comprises a gate region disposed under the storage means (5, 5A) and capacitively coupled thereto.

7. A semi-conductor memory as claimed in any of claims 3 to 5 characterised in that the first control gate means comprises a gate electrode (7) disposed over the storage means (5, 5A) and capacitively coupled thereto.

8. A semi-conductor memory as claimed in any of claims 3 to 7 characterised in that the second control gate means comprises a gate electrode (9A) disposed over the storage means (5A) and capacitively coupled thereto.

9. A semi-conductor memory as claimed in any of claims 3 to 8 characterised in that the random access means comprises input means (10, 10A) disposed in spaced relation from the first control gate (7), a channel region (4) for inputting volatile information to the first control gate means (7), and gate means (12, 12A) disposed on the channel region for turning on the channel region on a random access basis.

10. A semi-conductor memory according to any of claims 3 to 9 characterised in that the random access means includes a switching transistor connected to the gate means (12, 12A) to effect random access thereof.

11. A semi-conductor memory as claimed in claim 9 or 10 characterised in that the input means (10A), the gate means (12A) and the second control gate means (9A) are comprised of a thin film transistor.

FIG.1

FIG.2

FIG. 3

# FIG.4

103 102 91A 101 100 1

# FIG. 5

7 6 4 2 5 8 9 11 W109 113 110
51 3 12 10 112 111 1